# EUROPEAN PATENT APPLICATION

(11) **EP 4 766 128 A1**
(43) Date of publication of application: **24.06.2026**
(21) Application number: 24853578.3
(22) Date of filing: 01.08.2024

(54) **GALLIUM NITRIDE DEVICE AND PREPARATION METHOD THEREFOR**

(30) Priority: 15.08.2023 CN 202311034300
(71) Applicant: ZTE CORPORATION, Shenzhen, Guangdong 518057 (CN)
(72) Inventor: WU, Sheng, Shenzhen, Guangdong 518057 (CN); DAI, Yunfei, Shenzhen, Guangdong 518057 (CN); ZHANG, Yu, Shenzhen, Guangdong 518057 (CN); BIE, Yenan, Shenzhen, Guangdong 518057 (CN); LIU, Haijun, Shenzhen, Guangdong 518057 (CN); LI, Wenming, Shenzhen, Guangdong 518057 (CN)
(74) Representative: Chimini, Francesco
(86) International application number: PCT/CN2024/109261
(87) International publication number: WO 2025/036166

(57) **Abstract**

Provided in the embodiments of the present application are a gallium nitride device and a preparation method therefor. The gallium nitride device includes an epitaxial layer, wherein a gate electrode is arranged on the epitaxial layer, there are a plurality of Y-shaped nanochannels on the epitaxial layer under the gate electrode, and the plurality of Y-shaped nanochannels are formed by two rows of wedge-shaped grooves which are oppositely arranged.

## Description

### Cross-Reference to Related Application

The present disclosure is based on Chinese patent application no. CN202311034300.7 filed on August 15, 2023 and entitled "Gallium Nitride Device and Preparation Method therefor", and claims priority to the patent application, the disclosure of which is incorporated herein by reference in its entirety.

### Technical Field

The present disclosure relates to the field of semiconductors, and in particular, to a gallium nitride device and a preparation method therefor.

### Background

Gallium Nitride High Electron Mobility Transistors (GaN HEMTs), as third-generation wide-bandgap compound semiconductor devices, exhibit significant performance advantages in the millimeter-wave domain. In particular, driven by the 5G technology industry, millimeter-wave gallium nitride devices have broad application prospects in fields such as high-capacity ultra-high-speed mobile communications, high-resolution imaging radar, and secure communications. However, as higher operating frequencies are pursued, the linearity of the devices becomes an increasingly serious issue.

To address linearity problems, researchers have conducted studies on device-level high-linearity technologies for GaN HEMTs. Among these approaches, mainstream solutions focus on modulating the carrier velocity-field relationship under the gate or on improving the geometry of the gate-source capacitance. For example, a Fin HEMT adopts a structure in which Fins of different widths are integrated along the gate-width direction. The gate-source capacitance continuously increases with gate voltage, compensating for the mobility degradation of carriers at high gate voltages, thereby achieving a large transconductance gate swing and significantly improving device linearity. A dual-channel HEMT introduces an additional channel to compensate for the mobility degradation of the first channel and utilizes the coupling between the two channels to suppress the nonlinear variations of the access resistance, thereby increasing the device's Output Third-Order Intercept Point (OIP3). A Metal-Insulator-Semiconductor (MIS) HEMT is a structure in which a dielectric layer is added to a GaN HEMT, which can effectively increase the distance between the gate electrode and the device channel, thereby mitigating the mobility degradation trend of the two-Dimensional Electron Gas (2DEG) in the channel under high gate voltages and thus improving device linearity.

However, for high-frequency communication systems, these technical solutions each have certain critical limitations. For example, in Fin HEMT, the parasitic capacitances newly introduced by the three-dimensional fin-type structure become non-negligible at high current bias points, seriously degrading the frequency characteristics of the device. Dual-channel devices require extreme performance design tailored to specific material properties in order to achieve coupling between the two channels; otherwise, the currents in the two channels cannot increase linearly in a coordinated manner, which instead leads to device linearity degradation at the application level. MIS structures introduce new interface parasitics, which adversely affect device reliability. Therefore, developing a high-linearity technical solution that introduces minimal parasitics, has low implementation complexity, and is suitable for large-scale application is critically important to meet the demands of modern communication systems for high speed, high precision, and high reliability.

In summary, for the problem in the related art that the approach of using dual-channel coupling to improve device linearity has high implementation difficulty and is prone to causing linearity degradation of the device at the application level, no effective solution has yet been provided.

### Summary

Embodiments of the present disclosure provide a gallium nitride device and a preparation method therefor, which at least solve the problem in the related art that the approach of using dual-channel coupling to improve device linearity has high implementation difficulty and is prone to causing linearity degradation of the device at the application level.

According to some embodiments of the present disclosure, there is provided a gallium nitride device, including an epitaxial layer, a gate electrode being provided on the epitaxial layer, and a plurality of Y-shaped nanochannels being provided in the epitaxial layer below the gate electrode, wherein the plurality of Y-shaped nanochannels include two rows of wedge-shaped grooves arranged opposite each other.

According to some other embodiments of the present disclosure, there is provided a preparation method for a gallium nitride device. The method includes: preparing an epitaxial layer, a source electrode and a drain electrode; preparing a plurality of Y-shaped nanochannels on an upper surface of the epitaxial layer, wherein the plurality of Y-shaped nanochannels include two rows of wedge-shaped grooves arranged opposite each other; and preparing a gate electrode above the plurality of Y-shaped nanochannels.

According to still some other embodiments of the present disclosure, there is provided a chip, including the gallium nitride device in any embodiment of the present disclosure.

### Brief Description of the Drawings

Fig. 1 is a cross-sectional structural diagram of a gallium nitride device according to embodiments of the present disclosure;
Fig. 2 is a top-view structural diagram of Y-shaped nanochannels according to embodiments of the present disclosure;
Fig. 3 is a schematic diagram of an overall structure of a gallium nitride device according to embodiments of the present disclosure;
Fig. 4 is a cross-sectional structural diagram of a gallium nitride device according to embodiments of the present disclosure;
Fig. 5 is a top-view structural diagram of a gallium nitride device according to embodiments of the present disclosure;
Fig. 6 is a schematic diagram of an operating principle of a gallium nitride device according to embodiments of the present disclosure;
Fig. 7 is a schematic diagram of an operating principle of Y-shaped nanochannels according to embodiments of the present invention;
Fig. 8 is a schematic diagram of an operating principle of a gate electrode according to embodiments of the present disclosure;
Fig. 9 is a flowchart of a preparation method for a gallium nitride device according to embodiments of the present disclosure;
Fig. 10 is a flowchart of a key process for preparing a gallium nitride device according to embodiments of the present disclosure; and
Fig. 11 is a schematic diagram of a key process flow for preparing a gallium nitride device according to embodiments of the present disclosure.

### Detailed Description of the Embodiments

Hereinafter, embodiments of the present disclosure will be described in detail with reference to the accompanying drawings and in conjunction with the embodiments.

It should be noted that the terms "first", "second" etc. in the description, claims, and accompanying drawings of the present disclosure are used to distinguish similar objects, and are not necessarily used to describe a specific sequence or order.

Embodiments of the present disclosure provide a gallium nitride device, particularly a Gallium Nitride High Electron Mobility Transistor (GaN HEMT) device.

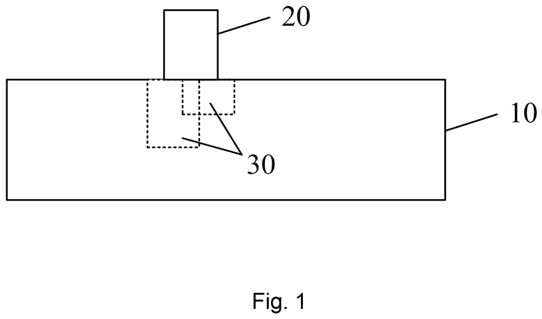

Fig. 1 is a cross-sectional structural diagram of a gallium nitride device according to embodiments of the present disclosure. As shown in Fig. 1, the gallium nitride device includes the following structures:
an epitaxial layer 10, a gate electrode 20 being provided on the epitaxial layer 10, and a plurality of Y-shaped nanochannels being provided in the epitaxial layer 10 below the gate electrode, wherein the plurality of Y-shaped nanochannels include two rows of wedge-shaped grooves 30 arranged opposite each other.

In the present embodiment, the epitaxial layer may include epitaxial materials (e.g., a channel layer, and a barrier layer) and isolation materials (e.g., a passivation layer).

In the embodiments of the present disclosure, the Y-shaped nanochannels formed by two rows of wedge-shaped grooves arranged opposite each other are provided in the epitaxial layer below the gate electrode. This can solve the problem in the related art that the approach of using dual-channel coupling to improve device linearity has high implementation difficulty and is prone to causing linearity degradation of the device at the application level. By performing staged control of the channel path under different gate biases, the device linearity can be significantly improved, while achieving advantages such as simple implementation, high efficiency, energy saving, and low cost.

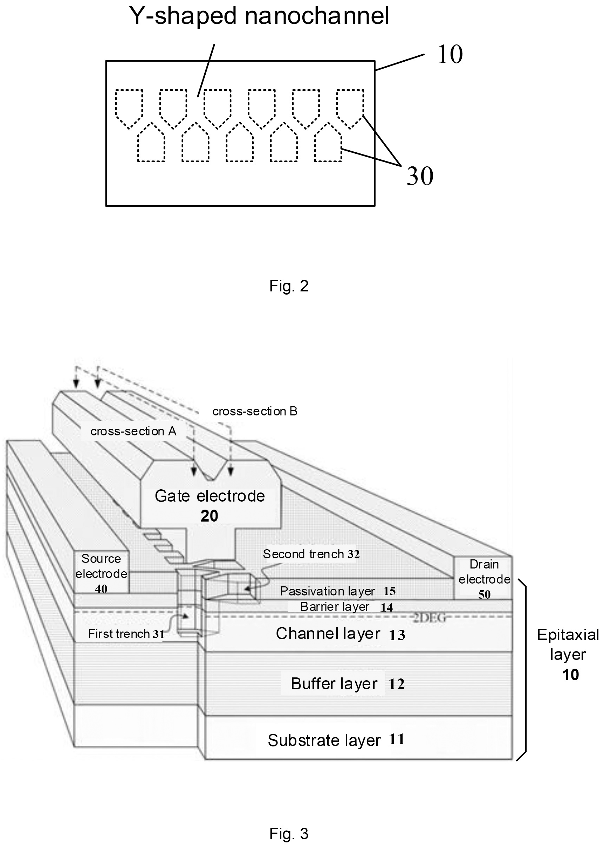

Fig. 2 is a top-view structural diagram of Y-shaped nanochannels according to embodiments of the present disclosure. As shown in Fig. 2, the Y-shaped nanochannels are formed by two rows of wedge-shaped grooves 30 arranged opposite each other.

In some embodiments, the two rows of wedge-shaped grooves are arranged in parallel, and each wedge-shaped groove 30 is composed of two parts, i.e. a pointed groove and a rectangular groove; the adjacent sides of the two rows of wedge-shaped grooves are pointed grooves, and the non-adjacent sides of the two rows of wedge-shaped grooves are rectangular grooves.

In some embodiments, the plurality of wedge-shaped grooves in the same row have the same shapes and sizes, and the shapes and sizes of the wedge-shaped grooves in different rows are not limited in the present disclosure.

In the embodiments of the present disclosure, by providing Y-shaped nanochannels, the motion paths of electrons are spatially confined, thereby reducing mutual scattering interference among electrons within the channel, suppressing nonlinear factors caused by scattering, and improving the linearity characteristics of the device. Accordingly, the problem in the related art that the approach of using dual-channel coupling to improve device linearity has high implementation difficulty and is prone to causing linearity degradation of the device at the application level can be addressed.

Fig. 3 is a schematic diagram of an overall structure of a gallium nitride device according to embodiments of the present disclosure. As shown in Fig. 3, the gallium nitride device further includes the following structures:
a source electrode 40 and a drain electrode 50.

In some embodiments, two ends of the epitaxial layer 10 are respectively provided with a source electrode and a drain electrode, and the plurality of Y-shaped nanochannels are located at the side close to the source electrode.

In some embodiments, the wedge-shaped grooves 30 include: a plurality of first trenches 31 and a plurality of second trenches 32, wherein the plurality of first trenches 31 are located adjacent to the source electrode, and the plurality of second trenches 32 are located adjacent to the drain electrode.

In some embodiments, the epitaxial layer 10 includes, from bottom to top: a substrate layer 11, a buffer layer 12, a channel layer 13, a barrier layer 14, and a passivation layer 15. The source electrode 40 and the drain electrode 50 are located on the upper surface of the barrier layer 14, the first trenches 31 extend into the channel layer and intercept the two-dimensional electron gas in the channel layer, and the second trenches 32 extend to the upper surface of the barrier layer.

In some embodiments, the adjacent sides of the first trenches and the second trenches are pointed grooves, and the non-adjacent sides of the first trenches and the second trenches are rectangular grooves.

In some embodiments, the plurality of first trenches and the plurality of second trenches are arranged in a staggered manner, wherein the pointed grooves of each first trench and two adjacent second trenches are staggered and opposite each other, the epitaxial layer material between the trenches may form a Y-shaped nanochannel; the pointed grooves of each second trench and two adjacent first trenches are staggered and opposite each other, and the epitaxial layer material between the trenches may also form a Y-shaped nanochannel.

In the present embodiment, by providing two rows of wedge-shaped grooves with different depths, segmented reusing of Y-shaped nanochannels can be realized under different gate biases, thereby further ensuring the linearity of a gallium nitride device under different gate biases.

In some embodiments, the gate electrode structure can be adjusted depending on the application scenarios. For example, the gate electrode may be of a floating T-shaped gate structure. Further, in high frequency environments, a floating T-shaped gate structure with V-shaped grooves may be used.

The embodiments of the present disclosure provide a millimeter-wave device with local stress modulation under the gate. By utilizing gradually varying in-situ SiN grooves to achieve different degrees of stress release under the gate, multi-threshold voltage regulation along the gate width direction is realized, enabling transconductance profile compensation of multi-threshold devices, thereby significantly improving device linearity. Simultaneously, by combining a low-insertion-loss floating T-shaped gate structure to reduce parasitic capacitance, the two key technical approaches of high-frequency performance and high linearity are effectively integrated, such that the device can achieve high-linearity applications in higher frequency bands.

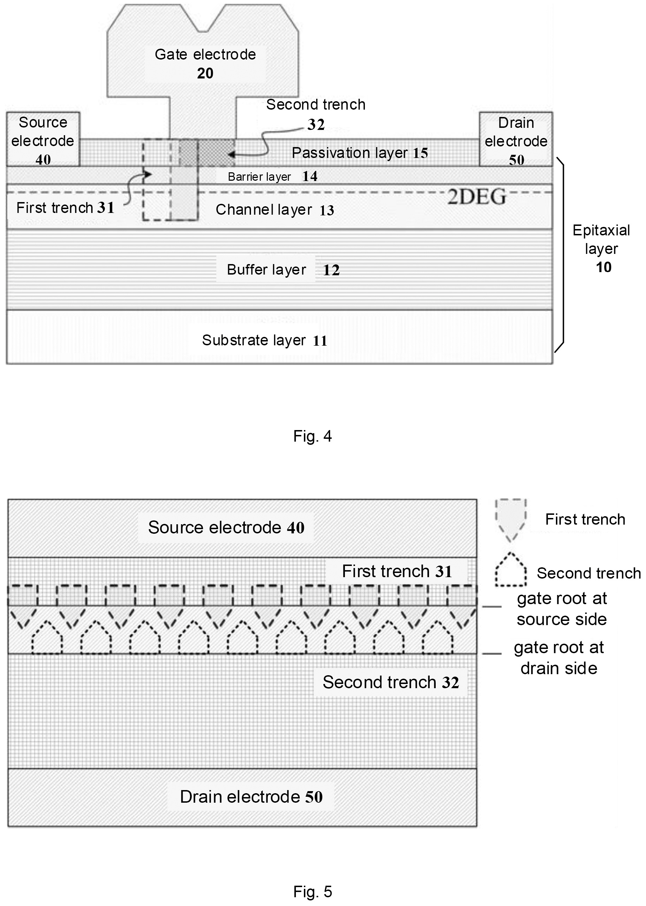

Fig. 4 is a cross-sectional structural diagram of a gallium nitride device according to embodiments of the present disclosure. As shown in Fig. 4, the root of a gate electrode 20 extends to the interior of wedge-shaped grooves.

In some embodiments, a first trench has a width of 1/3 to 1/2 of the gate length of the gate electrode in a gate width direction, and the first trench has a length of 2/3 to 1 of the gate length; a root of the gate electrode adjacent to the source electrode covers a portion of the pointed grooves of the first trenches.

In some embodiments, a second trench has a width of 1/3 to 1/2 of the gate length of the gate electrode in a gate width direction, and the second trench has a length of 1/2 to 2/3 of the gate length; a root of the gate electrode adjacent to the drain electrode covers all of the second trenches.

In some embodiments, the root metal of the gate electrode fills the pointed grooves of the first trenches, and both the pointed grooves and the rectangular grooves of the second trenches, and the gap positions (epitaxial layer material) between the root metals of the gate electrode form the Y-shaped nanochannels. Under different gate voltages, the gate electrode can achieve switching control of the Y-shaped nanochannels by means of the depletion effect of the metal material on the surrounding epitaxial layer material.

In some embodiments, a metal interconnect layer is further provided on the source electrode and the drain electrode.

In some embodiments, the material of the substrate layer includes at least one of the following: SiC, sapphire, Si, and GaN.

In some embodiments, the material of the buffer layer includes at least one of the following: GaN, AlGaN, and AlN.

In some embodiments, the material of the channel layer includes at least one of the following: GaN and InGaN.

In some embodiments, the material of the barrier layer includes at least one of the following: AlGaN, AlN, InAlN, ScAlN, InAlGaN, and N-plane GaN.

In some embodiments, the material of the passivation layer includes at least one of the following: SiN, SiO2, Al2O3, AlN, TaO, and LaO.

Further, if the barrier layer is made relatively thin, it may be unable to generate a sufficient two-Dimensional Electron Gas (2DEG) with the buffer layer by polarization. In this case, appropriately thick in-situ SiN may be provided above the barrier layer to enhance the polarisation of the barrier layer.

In the embodiments of the present disclosure, by introducing Y-shaped nanochannels jointly formed by three-dimensional wedge-shaped grooves and a three-dimensional gate electrode, the distribution and motion of carriers in the device can be effectively modulated in stages, thereby reducing intermodulation distortion and nonlinear characteristics and enabling the design of high-linearity power amplifiers. The system-level cost investment and design burden associated with Digital Pre-Distortion (DPD) for meeting linearity requirements of power amplifier modules can be reduced. This reduces the cost invested in key indicators and the design pressure of Digital Pre-Distortion (DPD) for the power amplifier module in the system.

Fig. 5 is a top-view structural diagram of a gallium nitride device according to embodiments of the present disclosure. As shown in Fig. 5, a root of a metal gate electrode covers a portion of the first trenches and all of the second trenches.

In the present embodiment, the gate metal in the first trenches is equivalent to the buried metal in a bulk material, and has a larger depletion range of the material than that of a conventional planar gate structure. By providing the gate metal in the trenches, the gallium nitride device can have a better off state.

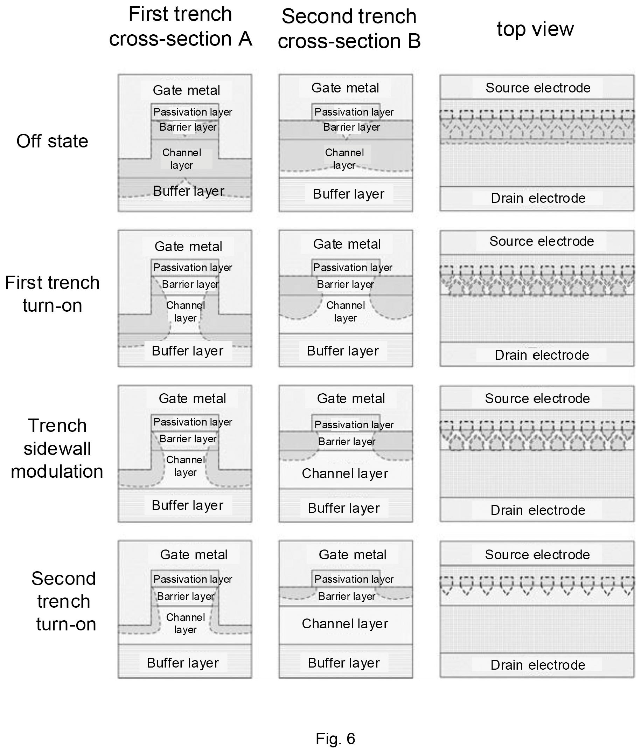

Fig. 6 is a schematic diagram of an operating principle of a gallium nitride device according to embodiments of the present disclosure. As shown in Fig. 6, the operating principle of the gallium nitride device can be divided into the following three states under different gate bias voltages:
an off state, an intermediate state, and a fully-on state. The intermediate state includes a first trench turn-on stage and a trench sidewall modulation stage, while the fully-on state corresponds to a second trench turn-on stage.

In the present embodiment, each stage is illustrated from the perspectives of cross-sectional views along sections A and B, as well as a top view. Further, cross-section A in Fig. 6 is a cross-sectional view taken along the cross-section A indicated in Fig. 3 and is used to illustrate the depletion range of the gate metal in the first trench, and cross-section B in Fig. 6 is a cross-sectional view taken along the cross-section B indicated in Fig. 3, and is used to illustrate the depletion range of the gate metal in the second trench.

In the present embodiment, the dashed lines schematically indicate the depletion range of the gate metal within the material. Due to the fundamental characteristics of metal-semiconductor junctions, as the gate bias voltage gradually changes from negative to positive, the depletion range of the gate metal within the material gradually contracts, and the depletion depth (width) is progressively released, thereby causing the device to turn on until it reaches saturation.

In the present embodiment, the first trench at cross-section A spatially confines the electron movement path by the gate metal on both sides, thereby reducing mutual scattering interference between electrons in the channel, suppressing nonlinear factors caused by scattering, and improving the linearity characteristics of the device.

In the present embodiment, the first trench at cross-section A reduces effective channel dimension beneath the gate due to trench etching, maintaining the current output capability of the gallium nitride device a stage with smaller source resistance, suppressing the trend of nonlinear source resistance increase caused by space charge limiting effects in the active region, and further improving the linearity of the gallium nitride device.

In the present embodiment, the second trenches at cross-section B form nanochannels directly beneath the gate electrode by the depletion effect of the planar gate electrode. As the gate bias voltage becomes more positive and the device approaches saturation, this gate depletion effect is appropriately relaxed to release the depletion of the underlying channel, thereby reducing the active region resistance on the gate-drain side in a parallel manner, further mitigating the space-charge-limited effect within the channel to a certain extent, and thus additionally improving the device linearity.

In the present embodiment, as the second trenches are turned on, the space available for electron movement on the gate-source side is smaller than that on the gate-drain side, resulting in a significantly higher electron concentration on the gate-source side compared to the gate-drain side. The concentration difference between the two sides provides a diffusive driving force for electron movement. When the device current approaches saturation, this concentration difference can also impart acceleration to electrons in the channel along the electron movement direction (from source to drain), thereby reducing the under-gate transit time and improving the frequency response of the device.

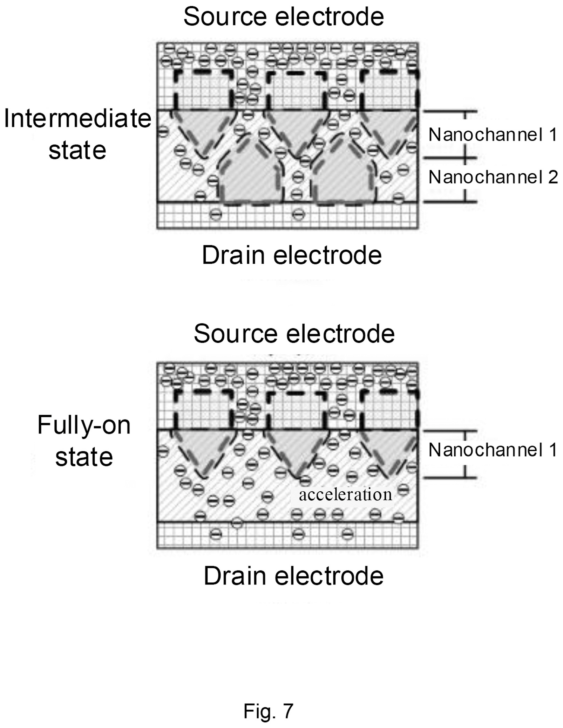

Fig. 7 is a schematic diagram of an operating principle of Y-shaped nanochannels according to embodiments of the present disclosure. As shown in Fig. 7, the Y-shaped nanochannels may be divided into nanochannel 1 (the source side) and nanochannel 2 (the drain side).

In the present embodiment, when the gallium nitride device gradually enters the fully-on state from the intermediate state, the nanochannel 2 is completely turned on, the electron concentration on the gate-source side is far higher than the electron concentration on the gate-drain side, and the concentration difference between the two sides provides diffusive driving power for electron movement.

Further, when the gallium nitride device enters the fully-on state and the device current approaches saturation, this concentration difference can impart acceleration to electrons in the channel along the electron movement direction (from source to drain), thereby reducing the under-gate transit time and improving the frequency response of the device, also ensuring that the gallium nitride device can satisfy applications with a higher frequency.

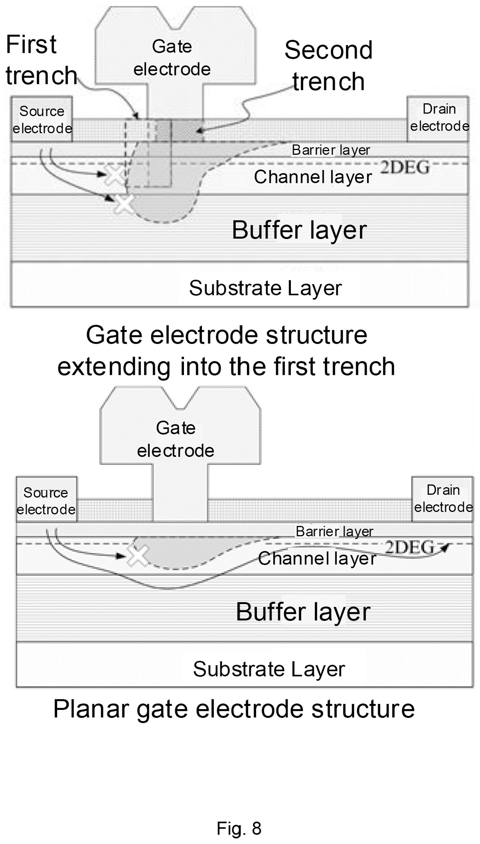

Fig. 8 is a schematic diagram of the operating principle of a gate electrode according to embodiments of the present disclosure. As shown in Fig. 8, the upper part illustrates the gate electrode structure in the embodiments of the present disclosure, in which the root of the gate electrode adjacent to the source electrode extends into the first trenches, while the lower part illustrates a planar gate electrode structure.

In the present embodiment, the gate metal within the first trenches is equivalent to buried metal in the bulk material, and its depletion range in the material is larger than that of a conventional planar gate structure, thereby enabling the gallium nitride device to achieve a better off state.

In the present embodiment, under the same driving voltage, compared with a planar gate electrode structure, the gate electrode structure in the embodiments of the present disclosure can block deeper source-drain current paths within the material when the device is in the off state, thereby enabling the gallium nitride device in the embodiments of the present disclosure have a smaller off-state current and stronger high-voltage stability.

According to some other embodiments of the present disclosure, further provided is a preparation method for a gallium nitride device, which is used for preparing the gallium nitride device in any one of the embodiments above.

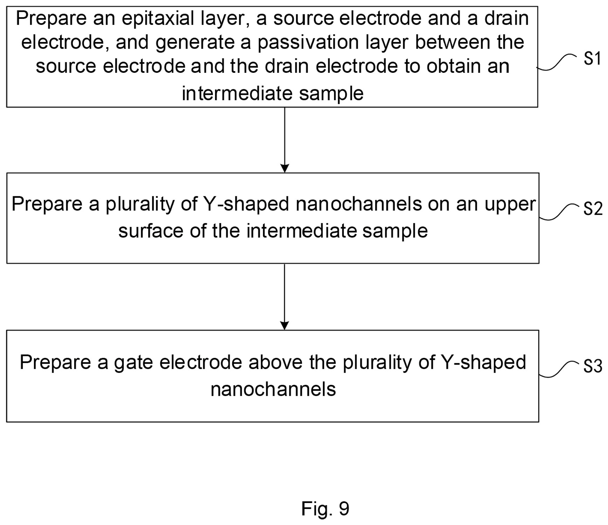

Fig. 9 is a flowchart of a preparation method for a gallium nitride device according to embodiments of the present disclosure. As shown in Fig. 9, the method mainly includes the following steps:
step S1, an epitaxial layer, a source electrode and a drain electrode are prepared, and a passivation layer is generated between the source electrode and the drain electrode to obtain an intermediate sample;
step S2, a plurality of Y-shaped nanochannels are prepared on an upper surface of the intermediate sample, wherein the plurality of Y-shaped nanochannels include two rows of wedge-shaped grooves arranged opposite each other; and
step S3, a gate electrode is prepared above the plurality of Y-shaped nanochannels.

In some embodiments, the epitaxial layer includes, from bottom to top: a substrate layer, a buffer layer, a channel layer and a barrier layer, and a passivation layer is provided on the barrier layer and can isolate and protect the epitaxial layer.

In some embodiments, preparing the epitaxial layer, the source electrode and the drain electrode in step S1 may include the following steps:
step S101, a buffer layer, a channel layer and a barrier layer are sequentially grown on the substrate layer; and
step S102, ohmic contacts are formed at two ends of the barrier layer by an implanted ohmic process or an annealed ohmic process to obtain the source electrode and the drain electrode.

In some embodiments, the wedge-shaped grooves include a plurality of first trenches and a plurality of second trenches.

Further, step S2 may include the following steps:
step S201, the side of the passivation layer close to the source electrode is etched by an Inductive Coupled Plasma-Reactive Ion Etching (ICP-RIE) process until reaching an interior of the channel layer to form the plurality of first trenches; and
step S202, the side of the passivation layer adjacent to the first trenches and close to the drain electrode is etched by the ICP-RIE process until reaching an upper surface of the barrier layer to form the plurality of second trenches.

In some embodiments, step S3 may include: a floating T-shaped gate structure is photolithographically formed above the plurality of first trenches and the plurality of second trenches, and a gate electrode is formed by an electron beam evaporation process, wherein a root of the gate electrode at the side close to the source electrode partially fills the first trenches, and a root of the gate electrode at the side close to the drain electrode completely fills the second trenches.

In some embodiments, step S101 may include: the buffer layer, the channel layer and the barrier layer are grew sequentially on the substrate layer by a Metal Organic Chemical Vapor Deposition (MOCVD) process or a Molecular Beam Epitaxy (MBE) process.

Further, after the step S101, the method may further include: in a case where the barrier layer has a thickness less than a preset value, in-situ SiN is grew on the barrier layer to enhance polarization of the barrier layer; and in a case where the barrier layer has a thickness equal to or greater than the preset value, the SiN is deposited by a Plasma Enhanced Chemical Vapor Deposition (PECVD) process so as to protect the barrier layer.

In the present embodiment, the preset value is used for determining the thickness of the barrier layer. If the thickness of the barrier layer is relatively thin (i.e. the thickness of the barrier layer is less than the preset value), a sufficient two-Dimensional Electron Gas (2DEG) cannot be generated with the buffer layer by polarization. Exemplarily, the preset value may be set to 8 nm, but the present disclosure is not limited thereto.

In some embodiments, after step S3, the method may further include:
step S4, a metal interconnection layer provided on the source electrode and the drain electrode is photolithographically formed and evaporated;
step S5, the source electrode, the drain electrode and the gate electrode are leaded out by a peripheral interconnecting process; and
step S6, the gallium nitride device is grounded by a through-hole process.

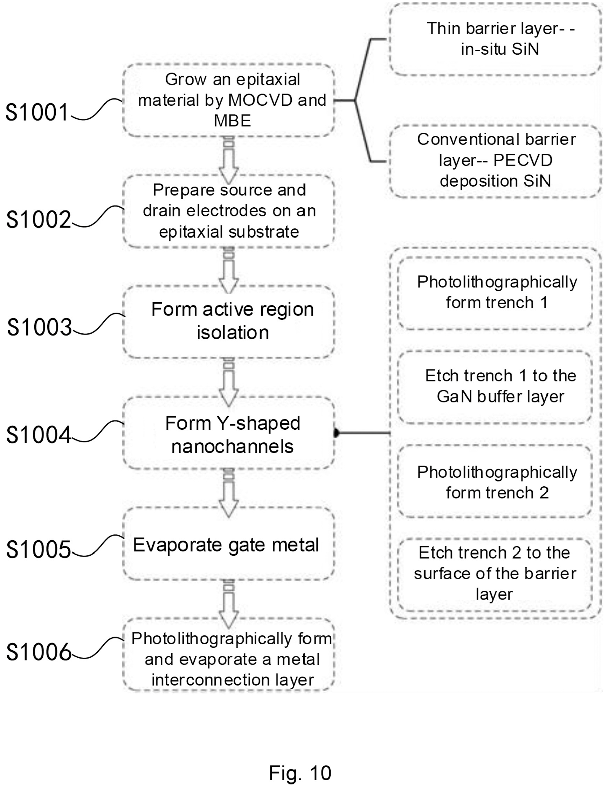

Fig. 10 is a flowchart of a key process for preparing a gallium nitride device according to embodiments of the present disclosure. As shown in Fig. 10, the process includes the following steps:
step S1001, an epitaxial material is grew by MOCVD and MBE;
step S1002, source electrode and drain electrode are formed on an epitaxial substrate;
step S1003, active region isolation is fabricated;
step S1004, Y-shaped nanochannels are prepared;
step S1005, a gate metal is evaporated; and
step S1006, a metal interconnection layer is photolithographically formed and evaporated.

In the present embodiment, step S1001, an insert layer, a buffer layer, a channel layer and a barrier layer may be sequentially grew on the substrate layer through a metal organic chemical vapor deposition process or a molecular beam epitaxy process.

In some embodiments, if the barrier layer in step S1001 is made relatively thin, it is unable to generate a sufficient two-Dimensional Electron Gas (2DEG) with the buffer layer by polarization. In such a case, the polarization of the barrier layer can be enhanced by providing an in-situ SiN layer of appropriate thickness above the barrier layer. If the barrier layer is of a conventional thickness, SiN may be deposited by a Plasma Enhanced Chemical Vapor Deposition (PECVD) process to protect the barrier layer.

In some embodiments, the active region isolation in step S1003 is equivalent to the passivation layer in the above embodiments, and is used for performing passivation protection on the material.

In some embodiments, step S1004 of preparing the Y-shaped nanochannels may include: the first trench is subject to photolithography, the first trench is etched to the buffer layer, the second trench is subject to photolithography, and the second trench is etched to the surface of the barrier layer.

The preparation process for the gallium nitride device in the embodiments of the present disclosure has high compatibility with conventional GaN HEMT device processes, features a simple implementation approach, and enables the achievement of high-linearity characteristics at low cost.

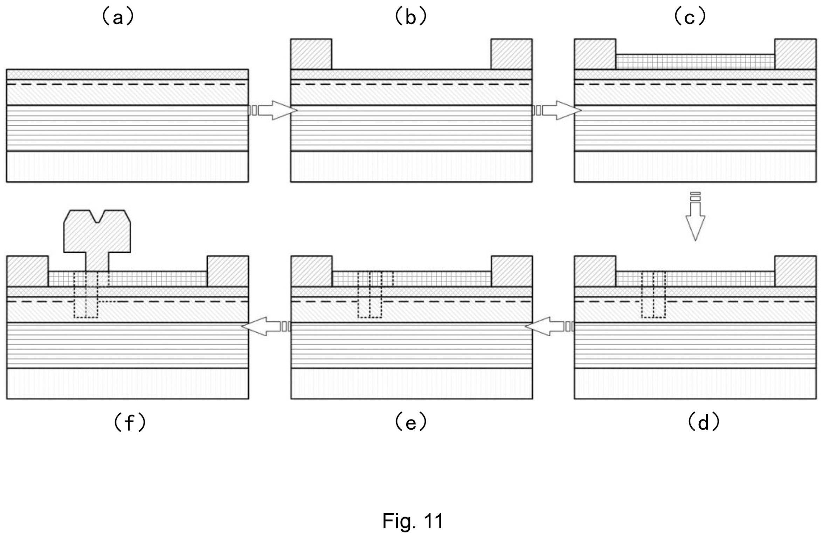

Fig. 11 is a schematic diagram of a key process flow for preparing a gallium nitride device according to embodiments of the present disclosure. As shown in Fig. 10, in the preparation process, the cross-section of the gallium nitride device sequentially changes from Fig. 11(a) to Fig. 11(f).

In the present embodiment, as shown in Fig. 11(a), the flow includes sequentially growing an insertion layer (not shown in the figure), a buffer layer, a channel layer and a barrier layer on a substrate (a substrate layer).

In some embodiments, the material of the substrate is one of SiC, sapphire or Si; the buffer layer is one of GaN, AlGaN or AlN; the channel layer is one of GaN or InGaN; and the barrier layer may be AlGaN, InAlN, AlN, ScAlN or other materials; it is also possible to grow in-situ SiN as epitaxial material is grown to enhance material properties if there is a special need.

In the present embodiment, as shown in Fig. 11(b), an injection or annealing process may be selected as required to prepare ohmic contacts (source electrode and drain electrode).

In some embodiments, the implanted ohmic process may include: photolithography patterning the source-drain implantation pattern, implanting a certain dose of Si ions, then photolithography patterning the source-drain metal pattern, followed by thermal annealing activation treatment to form ohmic contacts.

In some embodiments, the annealed ohmic process may include: photolithography patterning the source-drain pattern and depositing the source-drain metal, followed by thermal annealing to form ohmic contacts.

In the present embodiment, as shown in Fig. 11(c), passivation protection needs to be performed on the material.

In some embodiments, the material of the passivation layer includes but is not limited to dense materials such as SiN, SiO2, Al2O3, AlN, TaO, and LaO, and the thickness of the passivation layer is preferably 10-60 nm.

In the present embodiment, as shown in Fig. 11(d), an Inductive Coupled Plasma-Reactive Ion Etching (ICP-RIE) process may be used to etch a portion under the gate adjacent to the source electrode, with the etching terminating inside the channel layer, thereby forming the first trenches and implementing the first type of nanochannels.

In some embodiments, the first trench has a width of 1/3 to 1/2 of the gate length in a gate width direction, and has a length of 2/3 to 1 of the gate length, and the root of the gate electrode covers only a portion of the pointed grooves of the first trenches.

In some embodiments, the etching depth of the first trench may extend downward from the barrier layer surface by a distance of 2 times with reference to the barrier layer thickness.

In the present embodiment, as shown in Fig. 11(e), an Inductive Coupled Plasma-Reactive Ion Etching (ICP-RIE) process may be used to etch a portion under the gate adjacent to the drain electrode, with the etching terminating at the surface of the barrier layer, thereby forming the second trenches and implementing the second type of nanochannels. The second trenches and the first trenches jointly form a Y-shaped nanochannels in the material.

In some embodiments, the second trench has a width of 1/3 to 1/2 of a gate length in a gate width direction, and has a length of 1/3 to 1/2 of the gate length, with the gate root achieving complete metal coverage of the second trenches.

In some embodiments, the second trench is etched only through the passivation layer within the pattern and terminates at the upper surface of the barrier layer.

In some embodiments, after etching, the sample may further be placed in Tetra Methyl Ammonium Hydroxide (TMAH) solution for repair of etching damage.

In the present embodiment, as shown in Fig. 11(f), a floating T-shaped gate structure may be photolithographically patterned above the first trenches and the second trenches, followed by gate metal evaporation to form a low-insertion-loss floating T-shaped gate. The gate metal fills a portion of the first trenches to enhance gate control of the nanochannels, and completely fills the second trenches to realize staged control of the channels.

In some embodiments, the flow further includes performing peripheral interconnection processes to lead out electrodes, and performing through-hole processes to ground the device, thereby completing the final fabrication of the device.

The gallium nitride device provided according to the embodiments of the present disclosure has advantages such as simple implementation, high efficiency, energy saving, and low cost. It can reduce the circuit area of digital pre-distortion modules, lower costs, reduce implementation difficulty, and improve the overall performance of base station systems.

According to some other embodiments of the present disclosure, there is further provided a chip including the gallium nitride device according to any one of the above embodiments.

For specific examples in the present embodiment, reference can be made to the examples described in the above embodiments and exemplary embodiments, and thus they will not be repeated again in the present embodiment.

The content above merely relates to illustrative embodiments of the present disclosure and is not intended to limit the present disclosure. For a person skilled in the art, the present disclosure may have various modifications and variations. Any modifications, equivalent replacements, improvements, etc. made within the principle of the present disclosure shall all belong to the scope of protection of the present disclosure.

## Claims

1. A gallium nitride device, comprising an epitaxial layer, wherein a gate electrode is provided on the epitaxial layer, a plurality of Y-shaped nanochannels are provided in the epitaxial layer below the gate electrode, and the plurality of Y-shaped nanochannels comprise two rows of wedge-shaped grooves arranged opposite each other.

2. The gallium nitride device according to claim 1, wherein two ends of the epitaxial layer are respectively provided with a source electrode and a drain electrode, and the plurality of Y-shaped nanochannels are located at a side close to the source electrode.

3. The gallium nitride device according to claim 2, wherein the wedge-shaped grooves comprise a plurality of first trenches and a plurality of second trenches, wherein the plurality of first trenches are located at a side close to the source electrode below the gate electrode, and the plurality of second trenches are located at a side close to the drain electrode below the gate electrode.

4. The gallium nitride device according to claim 3, wherein the epitaxial layer comprises, from bottom to top: a channel layer, a barrier layer and a passivation layer, wherein the source electrode and the drain electrode are located on an upper surface of the barrier layer, the first trenches extend into the channel layer, and the second trenches extend to an upper surface of the barrier layer.

5. The gallium nitride device according to claim 3, wherein a wedge-shaped groove consists of a pointed groove and a rectangular groove, adjacent sides of the first trenches and the second trenches are pointed grooves, and non-adjacent sides of the first trenches and the second trenches are rectangular grooves.

6. The gallium nitride device according to claim 5, wherein the plurality of first trenches and the plurality of second trenches are arranged in a staggered manner.

7. The gallium nitride device according to claim 5, wherein,
a width of a first trench in a gate width direction is 1/3 to 1/2 of a gate length of the gate electrode, and a length of the first trench is 2/3 to 1 of the gate length; and
a root of the gate electrode adjacent to the source electrode covers a portion of the pointed grooves of the first trenches.

8. The gallium nitride device according to claim 5, wherein,
a width of a second trench in a gate width direction is 1/3 to 1/2 of a gate length of the gate electrode, and a length of the second trench is 1/2 to 2/3 of the gate length; and
a root of the gate electrode adjacent to the drain electrode covers all of the second trenches.

9. The gallium nitride device according to claim 1, wherein the gate electrode is of a floating T-shaped gate structure.

10. The gallium nitride device according to claim 2, wherein a metal interconnect layer is provided on the source electrode and the drain electrode.

11. The gallium nitride device according to claim 4, wherein,
material of the channel layer comprises at least one of the following: GaN and InGaN;
material of the barrier layer comprises at least one of the following: AlGaN, AlN, InAlN, ScAlN, InAlGaN, and N-plane GaN; and
material of the passivation layer comprises at least one of the following: SiN, SiO2, Al2O3, AlN, TaO, and LaO.

12. A preparation method for a gallium nitride device, the method comprising:
preparing an epitaxial layer, a source electrode and a drain electrode, and generating a passivation layer between the source electrode and the drain electrode to obtain an intermediate sample;
preparing a plurality of Y-shaped nanochannels on an upper surface of the intermediate sample,
wherein the plurality of Y-shaped nanochannels comprise two rows of wedge-shaped grooves arranged opposite each other; and
preparing a gate electrode above the plurality of Y-shaped nanochannels.

13. The method according to claim 12, wherein the epitaxial layer comprises, from bottom to top: a substrate layer, a buffer layer, a channel layer and a barrier layer, and preparing the epitaxial layer, the source electrode and the drain electrode comprises:
growing the buffer layer, the channel layer and the barrier layer on the substrate layer in sequence; and
forming ohmic contacts at two ends of the barrier layer by an implanted ohmic process or an annealed ohmic process to obtain the source electrode and the drain electrode.

14. The method according to claim 13, wherein the wedge-shaped grooves comprise a plurality of first trenches and a plurality of second trenches, and preparing a plurality of Y-shaped nanochannels on the upper surface of the intermediate sample comprises:
etching a side of the passivation layer close to the source electrode by an Inductive Coupled Plasma-Reactive Ion Etching, ICP-RIE, process until reaching an interior of the channel layer to form the plurality of first trenches; and/or
etching a side of the passivation layer adjacent to the first trenches and close to the drain electrode by the ICP-RIE process until reaching an upper surface of the barrier layer to form the plurality of second trenches.

15. The method according to claim 12, wherein the wedge-shaped grooves comprise a plurality of first trenches and a plurality of second trenches, and preparing the gate electrode above the plurality of Y-shaped nanochannels comprises:
photolithographically forming a floating T-shaped gate structure above the plurality of first trenches and the plurality of second trenches, and forming a gate electrode by an electron beam evaporation process, wherein a root of the gate electrode at a side close to the source electrode partially fills the first trenches, and a root of the gate electrode at a side close to the drain electrode completely fills the second trenches.

16. The method according to claim 13, wherein growing the buffer layer, the channel layer and the barrier layer sequentially on the substrate layer comprises:
growing the buffer layer, the channel layer and the barrier layer sequentially on the substrate layer by a Metal Organic Chemical Vapor Deposition, MOCVD, process or a Molecular Beam Epitaxy, MBE, process.

17. The method according to claim 16, wherein after growing the buffer layer, the channel layer and the barrier layer on the substrate layer sequentially, the method further comprising:
when a thickness of the barrier layer is less than a preset value, growing in-situ SiN on the barrier layer to enhance polarization of the barrier layer; and
when the thickness of the barrier layer is greater than or equal to the preset value, depositing SiN by a Plasma Enhanced Chemical Vapor Deposition, PECVD, process to protect the barrier layer.

18. The method according to claim 12, wherein after preparing the gate electrode above the plurality of Y-shaped nanochannels, the method further comprising:
photolithographically forming and evaporating a metal interconnection layer provided on the source electrode and the drain electrode;
leading out the source electrode, the drain electrode and the gate electrode by a peripheral interconnecting process; and
grounding the gallium nitride device by a through-hole process.

19. A chip, comprising the gallium nitride device according to any one of claims 1 to 11.
